Europäisches Patentamt

European Patent Office

Office européen des brevets

(11) Publication number: **0 229 488**
**A1**

# EUROPEAN PATENT APPLICATION

(21) Application number: 86309441.3

(22) Date of filing: 04.12.86

(51) Int. Cl.4: **H01L 21/68** , **C23C 14/16** , **C23C 16/30** , **H01L 21/31**

(30) Priority: 05.12.85 US 804716

(43) Date of publication of application:
22.07.87 Bulletin 87/30

(84) Designated Contracting States:
AT BE CH DE ES FR GB GR IT LI LU NL SE

(71) Applicant: ANICON, INC.
2240 Ringwood Avenue
San Jose California 95131(US)

(72) Inventor: Learn, Arthur J.
10822 Wilkinson Avenue
Cupertino California 95014(US)

(74) Representative: Armitage, Ian Michael et al
MEWBURN ELLIS & CO. 2/3 Cursitor Street
London EC4A 1BQ(GB)

(54) **Etch resistant wafer boat and process.**

(57) Quartz wafer boats which are designed for chemical vapor depositon (CVD) silicon dioxide coating processes are protected from silicon dioxide etchants by coating the boat surfaces with a material which is etchant resistant and acceptable in a CVD reaction chamber. Preferred coating materials are silicon nitride, polycrystalline silicon, amorphous silicon, silicon-boron, or combinations thereof. The etch resistant coating preferably has a thickness of at least 0.I micrometers.

Fig.2

## ETCH RESISTANT WAFER BOAT AND PROCESS

This invention relates to improved wafer boats for chemical vapor deposition (CVD) of silicon dioxide coatings on wafers. In particular, this invention relates to closed quartz wafer boats configured for silicon dioxide coating processes and having a uniform coating thereon of an etch resistant material which is acceptable in the CVD environment.

In batch coating of semiconductor wafers in many CVD processes, wafer boats supporting a plurality of wafers are introduced into the CVD reactor. The boats support the wafers in a position affording the desired exposure to the deposition gases and reduce handling and facilitate the loading and unloading process. For precision coating of silicon dioxide layers on wafers, the boats additionally protect the wafers from direct impingement by turbulent flowing gas carrying entrained particulate reaction products and control gas diffusion to the wafers. For vertical CVD reactors, a particularly useful boat for silicon dioxide coatings comprises two hemicylindrical sections having gas diffusion control openings in portions of the outer walls.

The spacing and orientation of the wafers are determined by precision slots cut or ground in a plurality of boat rails when the boat is originally manufactured. Precision holes are provided in the outer walls of closed wafer boats for diffusion of gases into the boat. Furthermore, the boat surface is roughened in some boats to provide a more constant boat surface area during the coating process. In the coating process, the wafer boat surfaces are exposed to the process gases and are coated along with the wafers. To prepare the boats for reuse, the coatings must be removed. This is accomplished by treating the boats with suitable chemical solutions which selectively remove the coating materials.

Quartz wafer boats used in silicon dioxide treatment processes present a particularly difficult problem since the quartz is also silicon dioxide, and any chemical solution which will dissolve silicon dioxide coatings will etch the quartz. The gas diffusion holes become etched and widened, no longer restricting the gas diffusion into the boat to the precise flow and flow patterns required for optimum precision coating. Simultaneously, the slots for positioning the wafers are etched, becoming wider and irregular, and eventually losing the dimensions required for supporting the wafers in an optimum orientation, and the controlled surface area of roughened boat surfaces are altered. These boats must be discarded, greatly limiting the useful life of the boats.

This invention is based on a discovery that by coating the quartz boats for silicon dioxide with uniform coatings of silicon nitride, polycrystalline silicon, amorphous silicon or silicon-boron mixtures, the boats are rendered etch resistant, and the silicon dioxide coatings formed in CVD process can be removed without significantly changing the dimensions of the slots, gas diffusion openings, or surface area of preroughened surfaces. The useful life of the boats can thus be greatly extended.

Coatings of silicon nitride, polycrystalline silicon, amorphous silicon and silicon-boron are applied to semiconductor wafers in some applications, and quartz wafer boats carrying these wafers are simultaneously coated. Wafer boats useful in these processes, however, do not have the configurations which are suitable for silicon dioxide coating CVD processes and are not the same as or equivalent to silicon dioxide CVD wafer boats. Coatings thereon are also cleaned with liquid etchants which are different from etchants used to remove silicon dioxide coatings.

According to the present invention there is provided a silicon dioxide coating quartz wafer boat having a configuration which is uniquely suitable for silicon dioxide coating CVD processes having a uniform, etch resistant coating on the external surfaces thereof which is resistant to etching by solutions containing hydrofluoric acid. The coating preferably comprises silicon nitride, polycrystalline silicon, amorphous silicon, silicon-boron, or combinations thereof. The etch resistant coating preferably has a thickness of at least 0.l micrometers.

A process for increasing resistance of quartz wafer boats to wet chemical etchants for removing silicon dioxide coatings comprises exposing the boat surface to reactant gases yielding coatings, which are resistant to the etchants, under the temperatures and pressures at which uniform coatings will be formed. Etch resistant silicon nitride coatings are formed at temperatures of 700 to 900°C, pressures of from l3 -l33 Pa (0.l to l.0 torr), and coating times e.g. of at least 50 minutes with a gas mixture of dichlorosilane and ammonia. Etch resistant amorphous silicon coatings are formed at temperatures of about 500 to 600°C and polycrystalline silicon coatings are formed at temperatures of about 600 to 700°C with pressures of from l3 -l33 Pa, and coating times e.g. of at least 30 minutes with silane or disilane. Etch resistant silicon-boron coatings are formed at temperatures of 300 to 500°C, pressures of from l3 -l33 Pa, and coating times e.g. of at least 60 minutes with gas mixtures of silane or disilane, and diborane.

In the accompanying drawings:

Figure I is a side view of a cylindrical wafer boat uniquely suitable for silicon dioxide coatings in a vertical hot wall CVD reactor.

Figure 2 is a cross-sectional view of the cylindrical wafer boat taken along the line 2-2 in Figure I.

Figure 3 is a fragmentary cross-sectional view of the lower wafer support rails taken along line 3-3 in Figure 2.

Figure 4 is a fragmentary cross-sectional view of the upper wafer support rails taken along line 4-4 in Figure 2.

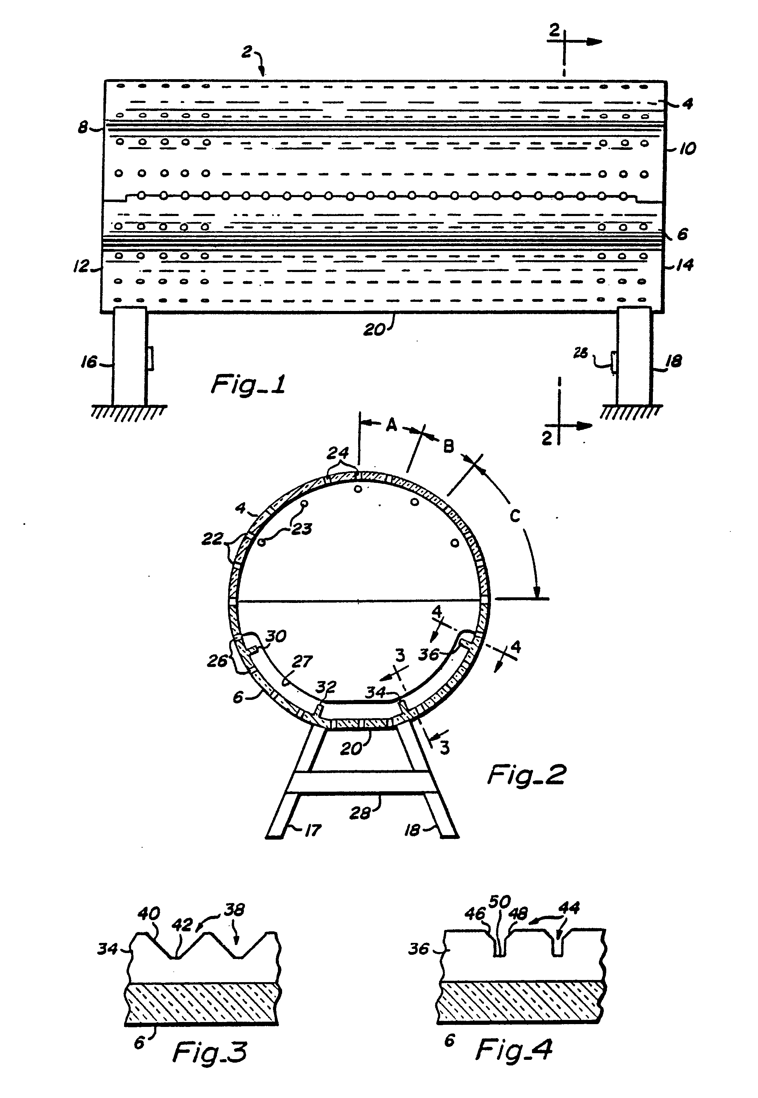

Quartz glassware is preferred for all internal surfaces of CVD reactors because of the high purity and stability at high temperatures. Quartz wafer boats are thus preferred in silicon dioxide treatment processes, even though they have a reduced life because of loss of quartz during the cleaning cycle. The chemical solution which dissolves silicon dioxide coatings also etches the quartz. In the most advanced CVD processes for silicon dioxide coating which yield the high coating uniformity required for VLSI devices, the wafers are enclosed in quartz boats to isolate the wafers from turbulent gas flow and suspended particles. Gas diffusion opening shape, placement and cross-sectional area, and wafer support structure have critical dimensions which directly affect coating uniformity. An example of such a quartz boat is shown in the Figures.

Figure I is a side view of the cylindrical wafer boat disclosed and claimed in US 4582020 (EP I6II0I). This boat is uniquely suitable for silicon dioxide coatings in a vertical hot wall CVD reactor. Figure 2 is a cross-sectional view taken along the line 2-2 in Figure I. The central axis of the cylindrical wafer boat 2 is horizontal, and wafers supported therein for coating are supported in an upright orientation.

The inner surfaces of the cylindrical walls have the shape of and conform to the outer edges of the individual wafers to be coated, being precisely spaced from the edges of the wafers. The cylindrical wafer boat 2 comprises an upper hemicylindrical section 4 and a lower hemicylindrical section 6 having mutually engaging opposed surfaces which join in a horizontal plane approximately through the central axis of the cylinder 2. The ends 8 and I0 of the upper hemicylinder and I2 and I4 of the lower hemicylinder are closed with gas flow passageways therein. Leg projections I6 and I8 project from the lower surface of hemicylinder 6 and are preferably integral therewith. The lower surface 20 of the hemicylinder 6 can be a flat section to engage the flat lower indexing edge typically present on a wafer, if desired. The leg projections I6 and I8 maintain the wafer boat in a stable orientation, precisely positioned in the reaction zone with the lower surface thereof preferably at least 7.5 mm above the supporting surface.

Referring to Figure 2, lower gas flow passageways 22 and upper gas flow passageways 24 are present in the sidewall portions of the upper hemicylinder constituting the diffusion zones thereof. The ends 8 and I0 are also diffusion zones, gas flow passageways 23 being positioned in the end walls 8 and I0. The lower passageways 22 are within the diffusion Zones C corresponding to Angle C in Figure 2. Sidewall Zones B corresponding to Angle B are closed and free of passageways. Angle C is from I0° to 75° and preferably from I0° to 60° of the horizontal plane dividing the cylinder into upper and lower hemicylinders. Additional openings 24 can be provided in the upper hemicylinder within Zone A corresponding to Angle A. Angle A is within I5° and preferably within I0° of the vertical plane through the axis of the cylinder 2. Passageways 22 and 24 can be circular holes, as shown, or can have oval, elliptical, rectangular, slotted or other cross-sectional shapes, if desired.

In one embodiment, the passageways 22 are positioned throughout the diffusion Zone C in a substantially even distribution. The cross-sectional area of the gas flow passageways can be from 0.5 to 80 percent, preferably from 0.5 to 40, and optimally from 0.5 to 20 percent of the total outer surface area of Zone C (including the portions occupied by holes). The upper and lower hemicylinders are preferably symmetrical about the vertical axis, and the Zones B and C are present on both sides of the vertical axis of the upper hemicylinder 4 in a symmetrical configuration.

The entire lower hemicylinder wall 6 is a gas diffusion zone and preferably has gas flow passageways 26. These are preferably uniformly distributed and can have the shapes described above with respect to the passageways in the upper hemicylinder 4. The cross-sectional area of the gas flow passageways 26 can be from 0.5 to 80 percent, preferably from 0.5 to 40, and optimally from 0.5 to 20 percent of the total outer surface area of the lower hemicylinder 6 (including the portions occupied by holes). The ends I2 and I4 also have gas flow passageways arranged to permit gas flow into the ends of the cylinder 2. In end closure I4, for example, the passageway 27 is an open slot having an arcuate shape adjacent the wall 6 conforming to the shape of the sidewall 6 and bottom wall 20. The passageways 27 in the ends I2 and I4 preferably occupy less than 20 percent of the end closure area.

The legs 16, 17 and 18 are supported by a cross-beam 28 preferably integral therewith. The legs 16, 17 and 18 are designed to support the cylindrical wafer boat 2 in a stable orientation during the coating operation. They are also designed to straddle and engage a loading fork projection - (not shown) of a loading apparatus, by which means the boats can be automatically and rapidly loaded and unloaded from the wafer support surface. Rails 30, 32, 34 and 36 maintain the wafers placed in the boat in a precisely spaced, upright position.

Figure 3 is a fragmentary cross-sectional view of the wafer boat taken along line 3-3 in Figure 2 showing details of the lower wafer support rails . The slots 38 in rail 34 have angularly sloped sides 40 tapering to merge with the bottom surfaces 42, maintaining the bottom of the wafers placed therein in a precisely determined spacing but leaving the wafer surface fully exposed.

Figure 4 is a fragmentary cross-sectional view of the wafer boat taken along line 4-4 in Figure 2 showing details of the upper wafer support rails. The slots 44 in rail 36 support the wafers placed therein in the vertical orientation. They have tapered portions 46 and 48 which facilitate loading and reduce the portion of the wafer surface masked by the slots when the wafers are bottomed against the slot surface 50.

The slots 38 and 44 position the wafers is a precise orientation and spacing, and are laser cut or ground to precise dimensions. Any variation in the dimensions changes the relative angle of the wafers and the spacing between adjacent wafer surfaces. Gas diffusion flows are a function of the cross-sectional areas for gas flow between the wafers, and coating irregularities are introduced by small changes in the dimensions of the slots. Removal of silicon dioxide coatings from boats used in silicon dioxide coating processes is required to avoid dimensional changes due to buildup of the coatings. Etchants useful for removing silicon dioxide coatings include hydrofluoric acid, usually diluted with water and optionally containing a buffer such as ammonium fluoride. The hydrofluoric acid unavoidably removes quartz surfaces of the boats, since quartz is silicon dioxide.

The quartz edges of the wafer support slots 38 and 44 are eroded by the etching solutions. The gas diffusion holes become etched and widened, no longer restricting the gas diffusion into the boat to the precise flow and flow patterns required for optimum precision coating. Simultaneously, the slots for positioning the wafers are etched, becoming wider and irregular, and eventually losing the dimensions required for supporting the wafers in an optimum orientation. The controlled surface area of roughened boat surfaces are altered. These boats must be discarded, greatly limiting the useful life of the boats.

This invention is based on a discovery that by coating the quartz boats for silicon dioxide with uniform coatings of silicon nitride, polycrystalline silicon, amorphous silicon or silicon-boron mixtures, the boats are rendered etch resistant, and the silicon dioxide coatings formed in the CVD process can be removed with the liquid silicon dioxide coating etchants without significantly changing the dimensions of the slots. The etch resistant coating preferably has a thickness of at least 0.1 micrometers and preferably at least 1.0 micrometers. The useful life of the boats can thus be greatly extended.

The process for increasing resistance of quartz wafer boats to wet chemical etchants for removing silicon dioxide coatings comprises exposing the boat surface to reactant gases yielding the coatings which are resistant to the etchants under the temperatures and pressures at which uniform coatings will be formed. Coating by chemical vapor deposition (CVD) is preferred over physical vapor deposition, such as evaporation or sputtering, because of the relative ease of achieving complete coating of all surfaces with CVD methods, although the physical vapor deposition methods can be used, if desired. The hot-wall CVD processes rather than the cold-wall CVD processes are preferred because of the inability to uniformly heat nonconductors in the latter processes. This is particularly important for pieces having irregular shapes in the third dimension. Hot-wall systems are generally operated at reduced pressure in order to improve coating uniformity and efficiency.

Any suitable CVD reactor can be used for carrying out the process, such as hot wall tube CVD reactors such as is described in U.S.Patent 4,098,923 and vertical hot wall tube CVD reactors such as are described in U.S.Patent No. 4,539,933, and the like. Application of boron-silicon coatings requires a vertical hot wall tube CVD reactor rather than a tube furnace because of the rapid coating of the reactor walls of the tube furnace and depletion of the siland and diborane reactants before they reach the objects to be coated. The coatings found to be useful for protecting the quartz surfaces have been previously applied in coating semiconductor wafers in CVD processes. The processes for providing these coatings are thus well known for coating semiconductor wafers, although they have not been previously used to provide such coatings on silicon dioxide coating boats.

Etch resistant silicon nitride coatings can be obtained with a gas mixture of dichlorosilane and ammonia at temperatures of 700 to 900C and preferably of from 800 to 850C; pressures of from 13 -133 Pa and preferably of from 27 -53 Pa (0.2 to 0.4 torr); with coating times e.g. of at least 50 minutes and preferably at least 100 minutes. Alternative gas mixtures which can be used to provide silicon nitride coatings include silane and ammonia at temperatures of 700 to 800C and preferably of from 750 to 800C, with pressures and coating times as described above.

Etch resistant amorphous and polycrystalline silicon coatings can be obtained with gas mixtures of silane or disilane at pressures of from 13 -133 Pa and preferably from 40 -80 Pa (0.3 to 0.6 torr); and coating times e.g. of at least 50 minutes and preferably at least 120 minutes. The amorphous silicon coating is obtained at coating temperatures of from 500 to 600C and preferably from 520 to 580C, and polycrystalline silicon coating is obtained at coating temperatures 600 to 700C and preferably of from 620 to 680C.

Etch resistant silicon-boron coatings can be obtained with gas mixtures of silane or disilane, and diborane, for example. The coatings can be obtained with these gases at temperatures of 300 to 500C and preferably of from 350 to 450C; pressures of from 13 -133 Pa and preferably of from 13 - 27 Pa (0.1 to 0.2 torr); and coating times e.g. of at least 60 minutes and preferably of at least 120 minutes. The ratio of silicon and boron can vary over the full range that impervious coatings can be achieved. Boron proportions in the boron-silicon coating can range from 0 wherein the coating would be a silicon coating up to 98 weight percent boron, for example. Alternative gas mixture include which can be used to provide silicon-boron coatings include disilane and diborane.

This invention is further illustrated by the following specific, but non-limiting examples. Temperatures are given in degrees centigrade unless otherwise specified. Descriptions of procedures which have been actually reduced to practice are given in a past tense, and procedures which are constructively reduced to practice by description herein are given in present tense.

Example 1

A quartz wafer boat specifically designed for silicon dioxide coatings was placed in a vertical hot wall CVD reactor having a coating zone with a temperature of 810C and a pressure of 30 Pa (0.225 torr). Dichlorosilane gas at a flow rate of 200 sccm (cm³/min) and ammonia gas at a flow rate of 600 sccm was introduced into the reactor. After 100 minutes, the gas flows were terminated, and the quartz boat having a uniform etch resistant coating of silicon nitride was removed from the reactor.

The boat was found to be resistant to etching by silicon dioxide coating removal etchants containing hydrofluoric acid.

Example 2

A quartz wafer boat specifically designed for silicon dioxide coatings was placed in a vertical hot wall CVD reactor having a coating zone with a temperature of 625C and a pressure of 26.6 Pa - (0.200 torr). Silane gas at a flow rate of 300 sccm was introduced into the reactor. After 100 minutes, the gas flows were terminated, and the quartz boat having a uniform etch resistant coating of polycrystalline silicon was removed from the reactor.

The boat was found to be resistant to etching by silicon dioxide coating removal etchants containing hydrofluoric acid.

Example 3

A quartz wafer boat specifically designed for silicon dioxide coatings was placed in a vertical hot wall CVD reactor having a coating zone with a temperature of 400C and a pressure of 16 Pa (0.120 torr). Silane gas at a flow rate of 175 sccm and diborane gas at a flow rate of 75 sccm was introduced into the reactor. After 60 minutes, the gas flows were terminated, and the quartz boat having a uniform etch resistant coating of a mixed composition of silicon-boron was removed from the reactor.

The boat is resistant to etching by silicon dioxide coating removal etchants including hydrofluoric acid.

Claims

1. A quartz wafer boat having a configuration which is suitable for silicon dioxide coating CVD processes having a uniform, etch resistant coating on the external surfaces thereof which is resistant to etching by solutions containing hydrofluoric acid.

2. A quartz wafer boat of claim 1 wherein the etch resistant coating comprises silicon nitride, polycrystalline silicon, amorphous silicon, silicon-boron, or combinations thereof.

3. A quartz wafer boat of claim 2 wherein the etch resistant coating comprises silicon nitride.

4. A quartz wafer boat of claim 2 wherein the etch resistant coating comprises amorphous silicon.

5. A quartz wafer boat of claim 2 wherein the etch resistant coating comprises polycrystalline silicon.

6. A quartz wafer boat of claim 2 wherein the etch resistant coating comprises boron-silicon.

7. A quartz wafer boat of any one of the preceding claims wherein the etch resistant coating has a thickness of at least 0.l micrometers.

8. A process for increasing resistance of a quartz wafer boat to wet chemical etchants for removing silicon dioxide coatings with a silicon nitride coating comprising exposing the wafer boat surface to dichlorosilane and ammonia at temperatures of 700 to 900°C and pressures of from l3 -l33 Pa until a uniform, contiguous coating of silicon nitride is formed on the wafer boat surface.

9. A process of claim 8 wherein the wafer boat surface is exposed to the dichlorosilane and ammonia at temperatures of from 800 to 850°C and pressures of from 27 to 53 Pa.

l0. A process for increasing resistance of a quartz wafer boat to wet chemical etchants for removing silicon dioxide coatings with a silicon nitride coating comprising exposing the wafer boat surface to silane and ammonia at temperatures of 700 to 800°C and pressures of from l3 to l33 Pa until a uniform, contiguous coating of silicon nitride is formed on the wafer boat surface.

ll. A process of claim l0 wherein the wafer boat surface is exposed to the silane and ammonia at temperatures of from 750 to 800°C and pressures of from 27 to 53 Pa.

l2. A process for increasing resistance of a quartz wafer boat to wet chemical etchants for removing silicon dioxide coatings with an amorphous silicon coating comprising exposing the wafer boat surface to silane, disilane or mixtures thereof at temperatures of 500 to 600°C and pressures of from l3 -l33 Pa until a uniform, continuous coating of amorphous silicon is formed on the wafer boat surface.

l3. A process of claim l2 wherein the wafer boat surface is exposed to the silane or disilane at temperatures of from 520 to 580°C and pressures of from 40 to 80 Pa.

l4. A process for increasing resistance of a quartz wafer boat to wet chemical etchants for removing silicon dioxide coatings with a polycrystalline silicon coating comprising exposing the wafer boat surface to silane, disilane or mixtures thereof at temperatures of 600 to 700°C and pressures of from l3 -l33 Pa until a uniform, continuous coating or polycrystalline silicon is formed on the wafer boat surface.

l5. A process of claim l4 wherein the wafer boat surface is exposed to the silane or disilane at temperatures of from 620 to 680°C and pressures of from 40 to 80 Pa.

l6. A process for increasing resistance of a quartz wafer boat to wet chemical etchants for removing silicon dioxide coatings with a boron-silicon coating comprising exposing the wafer boat surface to disilane, silane or mixtures thereof, and diborane at temperatures of 300 to 500°C and pressures of from l3 to l33 Pa until a uniform, contiguous coating of silicon-boron is formed on the wafer boat surface.

l7. A process of claim l6 wherein the wafer boat surface is exposed to silane and diborane at temperatures of from 350 to 450°C and pressures of from l3 to 27 Pa.

Fig_1

Fig_2

Fig_3

Fig_4

| | **DOCUMENTS CONSIDERED TO BE RELEVANT** | | EP 86309441.3 |
|---|---|---|---|
| Category | Citation of document with indication, where appropriate, of relevant passages | Relevant to claim | CLASSIFICATION OF THE APPLICATION (Int. Cl.4) |
| D,Y | EP - A2 - 0 161 101 (ANICON)<br>* Fig.; abstract *<br>-- | 1-4,8,<br>10,12 | H 01 L 21/68<br>C 23 C 14/16<br>C 23 C 16/30 |
| A | US - A - 4 524 719 (CAMPBELL)<br>* Fig.; abstract *<br>-- | 1 | H 01 L 21/31 |
| D,A | US - A - 4 539 933 (CAMPBELL)<br>* Fig.; abstract *<br>& EP-A2-0 137 702<br>-- | 1 | |
| Y | PATENT ABSTRACTS OF JAPAN, unex-<br>amined applications, C section,<br>vol. 5, no. 178, November 14, 1981<br>THE PATENT OFFICE JAPANESE GOVERN-<br>MENT<br>page 131 C 78<br><br>  * Kokai no. 56-102 577 (MIT-<br>    SUBISHI) *<br>-- | 1,2,4,<br>12 | |
| | | | **TECHNICAL FIELDS<br>SEARCHED (Int. Cl.4)** |
| A | EP - A1 - 0 051 449 (HAMAKAWA)<br>* Claims; abstract; fig. 1 *<br>-- | 1,2,4,<br>12 | H 01 L<br>C 23 C<br>C 23 F |
| Y | PATENT ABSTRACTS OF JAPAN, unex-<br>amined applications, C section,<br>vol. 8, no. 118, May 31, 1984<br>THE PATENT OFFICE JAPANESE GOVERN-<br>MENT<br>page 134 C 226<br><br>  * Kokai no. 59-31 863 (TOKYO<br>    SHIBAURA DENKI) *<br>-- | 1-3,8 | |

The present search report has been drawn up for all claims

| Place of search | Date of completion of the search | Examiner |
|---|---|---|
| VIENNA | 13-03-1987 | HEINICH |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO Form 1503 03 82

Application number

## EUROPEAN SEARCH REPORT

| | DOCUMENTS CONSIDERED TO BE RELEVANT | | EP 86309441.3 |

| Category | Citation of document with indication. where appropriate, of relevant passages | Relevant to claim | CLASSIFICATION OF THE APPLICATION (Int. Cl.4) |
|---|---|---|---|
| Y | US - A - 4 232 063 (ROSLER)<br>  * Claim 3; columns 3,4; examples 1,2 * | 1-3,10 | |
| A | DE - B2 - 1 544 287 (SIEMENS)<br>  * Claim; column 1, lines 33-49 * | 1-3,<br>10 | |
| A | CH - A - 474 858 (SIEMENS)<br>  * Claims 6,7 * | 1-3,8,<br>10 | |
| | | | TECHNICAL FIELDS<br>SEARCHED (Int. Cl.4) |

The present search report has been drawn up for all claims

| Place of search | Date of completion of the search | Examiner |
|---|---|---|
| VIENNA | 13-03-1987 | HEINICH |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82